# FASCICULE DE BREVET EUROPEEN

(11) **EP 0 441 684 B1**
(45) Date de publication et mention de la délivrance du brevet: **28.12.1994**
(21) Numéro de dépôt: 91400225.8
(22) Date de dépôt: 30.01.1991
(51) Int. Cl.: H03L 7/081, H03B 19/00

(54) **Circuit verrouillé en phase et multiplieur de fréquence en résultant**
Phasenregelschaltung und dadurch entstandener Frequenzvervielfacher
Phase lock circuit and resulting frequency multiplier

(30) Priorité: 06.02.1990 FR 9001366
(43) Date de publication de la demande: 14.08.1991
(73) Titulaire: BULL S.A., 92800 Puteaux (FR)
(72) Inventeur: Marbot, Roland, F-78470 Saint Remy Les Chevreuses (FR)
(74) Mandataire: Denis, Hervé

(56) Documents cités:
- EP-A- 0 102 598
- EP-A- 0 274 606
- IBM TECHNICAL DISCLOSURE BULLETIN. vol. 26, no. 3A, août 1983, NEW YORK US pages 990 - 991; HERNANDEZ: "FREQUENCY MULTIPLIER USING DELAY CIRCUITS"

## Description

L'invention se rapporte à un circuit verrouillé en phase et à un multiplieur de fréquence en résultant.

Le circuit classique verrouillé en phase est désigné couramment par l'acronyme PLL (Phase Locked Loop). Un PLL comprend : un comparateur de phase recevant le signal d'entrée et un signal de contre-réaction ; un filtre recevant le signal de sortie du comparateur de phase ; et un oscillateur commandé en tension, couramment appelé VCO (Voltage Controlled Oscillator), qui reçoit le signal de sortie du filtre, délivre le signal de sortie du PLL et commande une boucle de contre-réaction pour produire le signal de contre-réaction appliqué au comparateur de phase. Le filtre présente une fréquence de coupure relativement basse par rapport à la fréquence de l'oscillateur. L'oscillateur est généralement un générateur d'oscillations libres à une fréquence commandée analogiquement pour varier dans une bande de fréquences prédéterminée. On forme avec ce PLL un multiplieur de fréquence par N, en insérant un diviseur de fréquence par N dans la boucle de contre-réaction.

L'emploi d'un PLL présente plusieurs inconvénients majeurs. Le premier inconvénient réside dans la durée relativement longue pour obtenir un verrouillage de phase stable sur la fréquence de fonctionnement désirée du PLL. Cet inconvénient se présente au moment de la mise en marche du PLL, ou lors d'un changement de la fréquence de fonctionnement désirée du PLL. La durée d'établissement à un fonctionnement stable du PLL est due à la présence de la boucle de contre-réaction et dépend des caractéristiques électriques du PLL. La caractéristique la plus importante est la valeur de la fréquence de coupure du filtre par rapport à la fréquence de fonctionnement désirée du PLL. La durée d'établissement est d'autant plus longue que la fréquence de coupure est basse. Cependant, l'efficacité du verrouillage de phase est d'autant meilleure que la fréquence de coupure du filtre est basse. Par conséquent, il faut concéder un délai relativement important pour l'établissement du fonctionnement correct d'un PLL. Ce délai est ordinairement de plusieurs millisecondes et correspond donc au passage de nombreuses données que le PLL ne peut pas traiter.

Un second inconvénient de l'emploi d'un PLL est sa sensibilité aux bruits éléctriques induits sur le signal analogique de commande du VCO, qui produisent une instabilité temporaire (jitter) de la fréquence de sortie du PLL.

Comme troisiéme inconvénient, la bande de fréquences de fonctionnement d'un PLL est relativement étroite pour deux raisons. D'une part, les deux signaux d'entrée du comparateur de phase n'ont pas la même phase et la même fréquence. La réalisation d'un comparateur à large bande de fréquence et de phase s'avère très difficile et très encombrante dans un circuit intégré. D'autre part, on a vu que la commande analogique de l'oscillateur est très sensible aux bruits électriques. Par conséquent, les bruits intervenant dans une large bande de fréquences induiraient de trop grandes variations de fréquences dans le signal de sortie et compromettraient la stabilité de fonctionnement du PLL.

La commande de phase analogique de l'oscillateur d'un PLL est aussi la cause d'un quatrième inconvénient. Cet inconvénient est particulièrement mis en relief dans l'exemple suivant. Actuellement, l'activation d'une liaison de transmission dans un circuit intégré produit une dissipation thermique relativement élevée, de l'ordre de 0,5 watt par exemple. Par conséquent, si on veut y intégrer un nombre important (32 par exemple) de liaisons, il est seulement possible d'en activer un petit nombre (4 ou 8). Un procédé consiste à mettre en sommeil les autres liaisons et à les réveiller sélectivement pour les activer. Etant donné que le réveil doit se faire en un temps très court, il faut mettre numériquement en mémoire tous les réglages propres à chaque liaison. La commande de phase analogique d'un PLL interdit donc un réveil rapide des liaisons. Cet inconvénient se cumule avec le premier inconvénient cité.

L'invention remédie à tous ces inconvénients, en présentant un circuit verrouillé en phase et un multiplieur de fréquence ayant une brève durée d'établissement du fonctionnement correct, insensibles aux bruits électriques, applicables à une large bande de fréquences de fonctionnement et pourvus d'une commande numérique.

L'invention présente un circuit verrouillé en phase, comprenant un comparateur de phase recevant un signal d'entrée et un signal de contre-réaction, caractérisé en ce que le signal de contre-réaction ainsi que les signaux de sortie sont produits par un circuit à retard de phase variable du signal d'entrée, dont le retard est commandé par le signal de sortie du comparateur de phase.

Il en résulte un multiplieur de fréquence conforme à l'invention, comprenant un comparateur de phase recevant un signal d'entrée et un signal de contre-réaction, caractérisé en ce que le signal de contre-réaction est produit par un circuit à retard produisant des retards successifs de phase du signal d'entrée commandés par le signal de sortie du comparateur de phase, et en ce que le signal de sortie du multiplieur est délivré par un additionneur logique des signaux retardés.

Les caractéristiques et avantages de l'invention ressortent clairement de la description qui suit, donnée à titre d'exemple et faite en référence aux dessins annexés.

Dans les dessins :
- la figure 1 illustre schématiquement un circuit verrouillé en phase conforme à l'invention ;
- la figure 2 présente diverses formes d'onde de signaux prélevés du circuit verrouillé en phase représenté sur la figure 1 afin d'en illustrer le fonctionnement ;
- la figure 3 illustre schématiquement un multiplieur de fréquence conforme à l'invention, résultant de la mise en oeuvre du circuit verrouillé en phase représenté sur la figure 1 ;
- la figure 4 présente diverses formes d'onde de signaux prélevés du multiplieur de fréquence représenté sur la figure 3 afin d'en illustrer le fonctionnement ;
- la figure 5 illustre schématiquement une variante de réalisation d'un multiplieur de fréquence conforme à l'invention ; et
- la figure 6 présente des formes d'ondes de signaux prélevés du multiplieur de fréquence représenté sur la figure 5 pour en illustrer le fonctionnement.

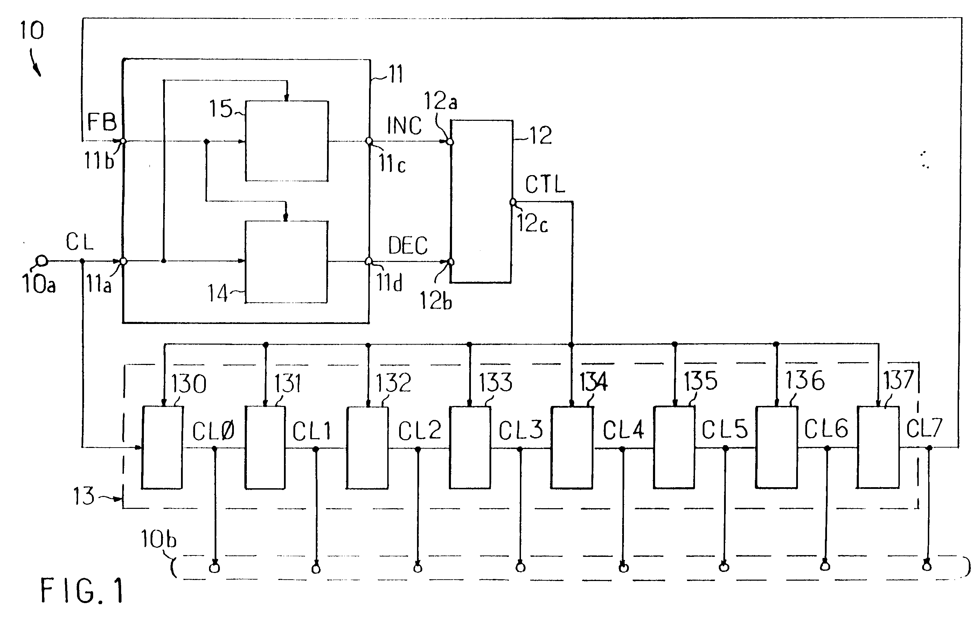

La figure 1 illustre un mode de réalisation préféré d'un circuit verrouillé en phase 10 conforme à l'invention. Le circuit 10 comprend : une borne d'entrée 10a ; un comparateur de phase 11 ayant une première borne d'entrée 11a connectée à la borne d'entrée 10a du circuit 10, une seconde borne d'entrée 11b et deux bornes de sortie 11c, 11d ; un compteur-décompteur 12 ayant deux bornes d'entrée 12a, 12b connectées respectivement aux bornes de sortie 11c, 11d du comparateur de phase 11 et une borne de sortie 12c ; un circuit à retard de phase 13 composé de huit éléments de retard 130-137 connectés en série entre les deux bornes d'entrée 11a et 11b du comparateur de phase 11 et pourvus chacun d'une borne de commande connectée à la borne de sortie 12c du compteur-décompteur 12 ; et une sortie 10b formée par les bornes de sortie respectives des éléments de retard 130-137.

Le comparateur de phase 11 se compose de deux bascules maître-esclave 14 et 15 sensibles aux fronts montants. La bascule 14 a son entrée de données connectée à la borne d'entrée 11a, son entrée d'horloge connectée à la borne d'entrée 11b, et sa sortie connectée à la borne de sortie 11d. La bascule 15 a, de façon similaire, son entrée de données connectée à la borne d'entrée 11b, son entrée d'horloge connectée à la borne d'entrée 11a et sa sortie connectée à la borne de sortie 11c.

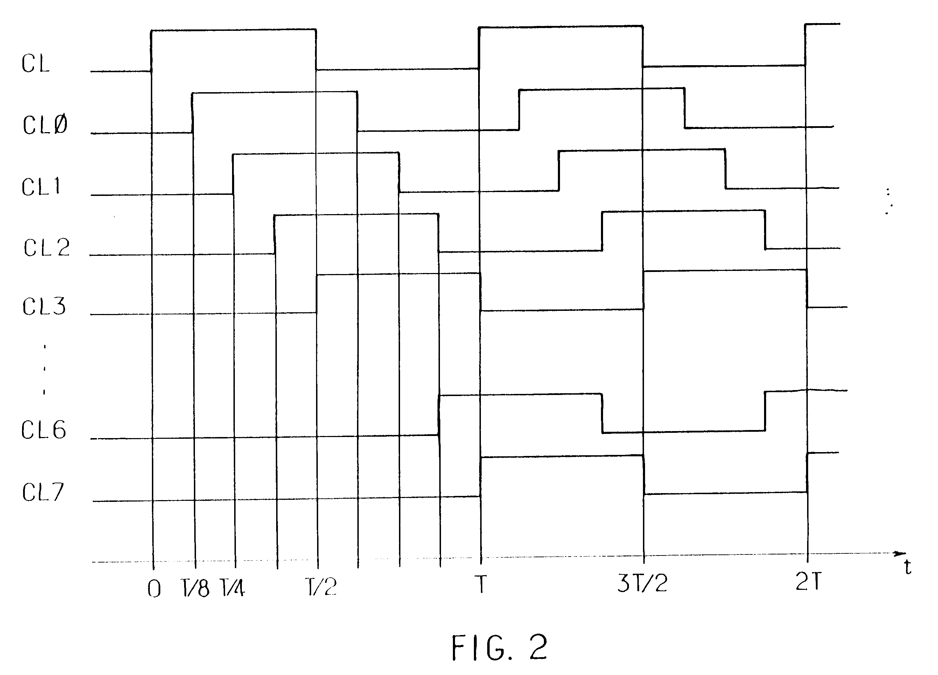

La borne d'entrée 10a du circuit 10 reçoit un signal d'entrée CL de fréquence donnée correspondant à une période T et constituant ordinairement un signal d'horloge. La figure 2 représente un exemple de forme d'onde du signal d'entrée CL par rapport à l'axe des temps t. Dans la figure 2, il est supposé que le signal d'entrée CL est appliqué à l'instant t = 0 sur la borne d'entrée 10a. La figure 2 illustre les formes d'onde des signaux de sortie CL0, CL1, CL2, CL3,..., CL6 et CL7 des éléments de retard respectifs 130, 131, 132, 133,..., 136 et 137 du circuit à retard de phase 13. Les signaux CL0-CL7 sont présentés à la borne de sortie 10b du circuit 10. La borne de contre-réaction 11b du comparateur de phase 11 reçoit un signal de contre-réaction FB constitué par le signal de sortie CL7 du circuit à retard 13. Le comparateur 11 compare donc la phase du signal de sortie CL7 avec celle du signal d'entrée CL. Les deux bornes de sortie 11c et 11d du comparateur de phase 11 délivrent respectivement un signal d'incrémentation INC et un signal de décrémentation DEC. En réponse, le compteur-décompteur 12 fournit le signal de commande CTL appliqué aux éléments de retard 130-137. Chaque élément de retard se compose, de manière classique, d'un nombre prédéterminé de cellules de retard élémentaire. Le signal de commande CTL représente une valeur numérique, qui est appliquée à chaque élément de retard pour en faire varier la durée du retard. La plage de variation possible de la durée du retard d'un élément de retard au cours d'une période T du signal d'entrée CL correspond à une fraction prédéterminée 1/P de l'étendue maximale de la variation de durée d'un élément de retard. En d'autres termes, il faut un nombre entier donné P de périodes T pour passer de l'une à l'autre des valeurs extrêmes de l'étendue maximale de variation du retard d'un élément.

En fonctionnement, le signal d'entrée CL est retardé successivement par les huit éléments de retard 130-137. Les huit retards successifs produits par les éléments 130-137 sont égaux et divisent en principe la période T du signal d'entrée CL. S'il en est exactement ainsi en pratique, les signaux CL et FB (CL7) entrant dans le comparateur de phase 11 et appliqués aux bascules maître-esclave 14 et 15 ont la même phase et la même fréquence. Les signaux DEC et INC délivrés par les bascules 14 et 15 ont donc la même valeur logique. Le compteur-décompteur 12 n'est donc pas activé et laisse le signal de commande CTL inchangé. Tous les signaux de sortie CL0-CL7 sont correctement déphasés les uns par rapport aux autres et par rapport au signal d'entrée CL d'une même valeur T/8. En pratique, on détermine une marge de tolérance m de déphasage entre le signal d'entrée CL et le signal de contre-réaction FB = CL7. Un déphasage dans la marge m laisse les signaux INC et DEC inchangés et n'est donc pas assimilé à un déphasage à corriger. La marge m peut être déterminée par les temps d'établissement des bascules 14 et 15 et/ou par des retards relatifs entre les signaux d'entrée de données et d'entrée d'horloge de chaque bascule, par exemple. La largeur de la marge m détermine la précision de la comparaison de phase effectuée par le comparateur 11. Elle est typiquement de l'ordre de 50ps pour une période T = 5 ns du signal d'entrée CL.

Si le signal de contre-réaction FB est en avance de phase sur le signal d'entrée CL, le signal de décrémentation DEC a la valeur logique 0 et le signal d'incrémentation a la valeur 1. Le compteur-décompteur 12 est donc incrémenté pour que le signal de commande CTL augmente en conséquence et de manière égale les durées des retards produits par les éléments 130-137. Au contraire, si le signal de contre-réaction FB est en retard sur le signal d'entrée CL, le signal d'incrémentation INC a la valeur 0 et le signal de décrémentation DEC a la valeur 1. Le compteur-décompteur 12 est décrémenté pour que le signal de commande CTL diminue équitablement les durées des retards produits par les éléments 130-137. Par conséquent, un déphasage au-delà de la marge de tolérance m est corrigé au niveau de tous les éléments de retard 130-137 pour rétablir les déphasages désirés.

La commande de phase numérique mise en oeuvre dans le circuit verrouillé en phase 10 conforme à l'invention offre un avantage important. Si le signal d'entrée CL est interrompu, par principe le signal de contre-réaction FB est aussi interrompu. Les bascules 14 et 15 du comparateur de phase 11 ne reçoivent donc plus de signal sur leur entrée d'horloge et conservent donc chacune le dernier état de la transmission. De même, le compteur-décompteur 12 conserve son dernier état et, par conséquent, l'état des éléments de retard 131-138. En d'autres termes, le circuit 10 conforme à l'invention conserve le dernier état de la transmission. Il s'ensuit que la réapparition du premier front du signal d'entrée CL produira immédiatement les signaux de sortie CL0-CL7 corrects si la fréquence du signal d'entrée CL n'a pas changé. Sinon, les retards sont réglés par le compteur-décompteur 12 dès le second cycle du signal d'entrée CL, en vue de produire les signaux de sortie CL0-CL7 désirés. En conclusion, la durée d'établissement du fonctionnement correct d'un circuit verrouillé en phase conforme à l'invention peut être nulle, ou au pire égale au nombre P précité de périodes T du signal d'entrée pour passer entre les deux valeurs extrêmes de l'étendue de variation de la durée de chaque élément de retard. Par conséquent, la mise en marche du circuit conforme à l'invention ou le réveil d'une ligne de transmission se font très brièvement.

Un second avantage majeur réside dans la large bande de fréquences de fonctionnement du circuit verrouillé en phase conforme à l'invention. La largeur de la bande dépend essentiellement de la gamme de retards variables de chaque élément de retard 130-137, comme cela ressortira ultérieurement en référence au multiplieur de fréquence conforme à l'invention.

Comme autre grand avantage, le signal d'entrée CL et le signal de contre-réaction FB qui sont comparés par le comparateur de phase 11 ont par principe la même fréquence. La structure du comparateur 11 peut être très simple, comme celle illustrée. En outre, le comparateur peut s'accommoder à une grande bande de fréquences de fonctionnement. En résumé, l'invention résout tous les problèmes précités que posent l'emploi d'un PLL classique. Un autre avantage offert par un circuit 10 conforme à l'invention réside dans son adaptation aux diverses formes du signal d'entrée. Dans l'exemple illustré, le rapport cyclique du signal d'entrée peut être quelconque.

De nombreuses variantes de réalisation peuvent être apportées au circuit 10 décrit et illustré. Notamment, il est clair que le circuit à retard 13 peut avoir un nombre quelconque N d'éléments de retard. A la limite, le circuit à retard 13 peut être fait d'un seul élément de retard variable. Dans ce cas, le circuit 10 pourrait par exemple servir de dispositif de déphasage d'une période T d'un signal d'entrée CL pouvant varier dans une très large bande de fréquences. En outre, les éléments de retard 130-137 peuvent avoir une autre structure que celle décrite précédemment. On connait par exemple des éléments de retard correspondant au temps de traversée d'une porte logique. Le temps de traversée est commandé par l'intensité du courant qui traverse la porte, ou par la valeur de la charge appliquée à la porte. Dans ce cas, le compteur-décompteur 12 devrait être remplacé par un dispositif de commande approprié au fonctionnement de tels éléments de retard. Le principe général de l'invention est donc que le circuit à retard 13 est commandé par le signal de sortie du comparateur de phase 11. L'avantage du compteur-décompteur 12 et des éléments de retard 130-137 décrits réside notamment dans leur simplicité de structure et de fonctionnement, leur fiabilité et leur adaptation au comparateur de phase décrit. On a vu les avantages de ce comparateur. Bien entendu, d'autres structures sont possibles et peuvent être mieux adaptées à celles du dispositif de commande 12 du circuit à retard 13.

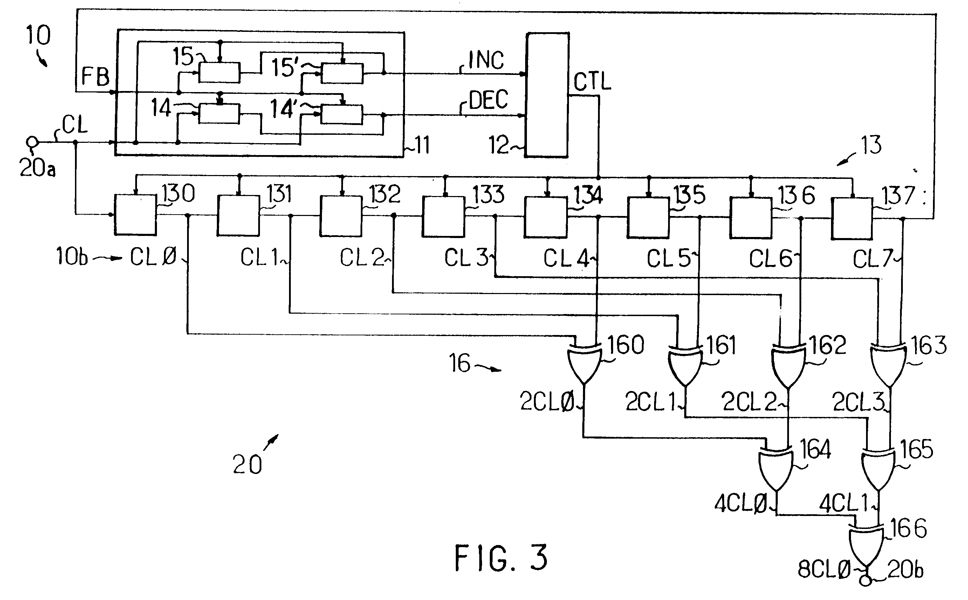

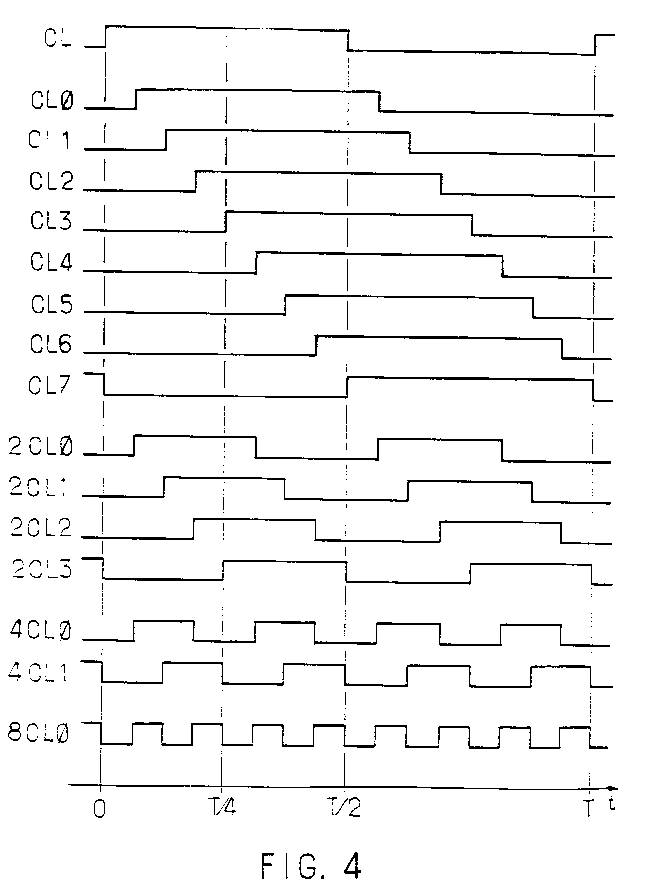

La figure 3 illustre un multiplieur de fréquence 20 conforme à l'invention, mettant en oeuvre le circuit verrouillé en phase 10 représenté sur la figure 1. Le multiplieur 20 comprend simplement le circuit 10, dont la borne d'entrée 10a constitue la borne d'entrée 20a du multiplieur 20 et dont la sortie 10b est connectée à l'entrée d'un additionneur logique 16. La sortie de l'additionneur 16 constitue la borne de sortie 20b du multiplieur de fréquence 20. Les figures 3 et 4 illustrent une variante d'utilisation conforme à l'invention du circuit verrouillé en phase 10. Selon cette variante, le comparateur de phase 11 incorpore deux bascules maître-esclave 14′, 15′ déclenchant sur les fronts descendants du signal d'entrée CL. Les bascules 14′ et 15′ sont disposées de la même manière que les bascules 14 et 15 déclenchant sur les fronts montants du signal d'entrée CL. Grâce à cette variante, la comparaison de phase se fait toutes les demi-périodes T/2 du signal d'entrée CL. Par conséquent, les signaux de sortie CL0-CL7 sont successivement décalés par rapport à chaque front du signal d'entrée carré CL d'une durée T/16 produite par chaque élément de retard 130-137.

L'additionneur 16 est fait de manière classique d'un montage en arbre de sept portes OU Exclusif 160-166 à deux entrées. Les quatre portes 160-163 reçoivent respectivement les signaux de sortie CL0 et CL4, CL1 et CL5, CL2 et CL6, CL3 et CL7. Les portes 160-163 délivrent respectivement les signaux de sortie 2CL0-2CL3 représentés sur la figure 4. Les signaux 2CL0-2CL3 sont carrés, ayant une fréquence double de celle du signal d'entrée CL. Les portes 164 et 165 reçoivent respectivement les signaux de sortie des portes 160, 162 et 161, 163 et délivrent les signaux 4CL0 et 4CL1 représentés sur la figure 4. Les signaux 4CL0 et 4CL1 sont carrés, ayant une fréquence quadruple de celle du signal d'entrée CL. Leur application sur la dernière porte 166 fournit le signal de sortie 8CL0 sur la borne de sortie 20b du multiplieur 20. Comme représenté sur la figure 4, le signal 8CL0 est carré et a une fréquence huit fois supérieure à celle du signal d'entrée CL.

En pratique, la réalisation en circuits intégrés de l'additionneur logique 16 doit conférer des temps de propagation égaux entre les sorties des éléments de retard 130-137 et la sortie 20b de l'additionneur. Cette contrainte assure la qualité de la fréquence multiple. D'autre part, l'emploi de l'additionneur 16 tel qu'illustré nécessite des décalages de phase de T/16 entre les signaux CL et CL0-CL7. Dans le multiplieur 20 recevant un signal d'entrée carré, ces décalages sont simplement produits par huit éléments de retard réglés à chaque demi-période T/2 après comparaison de phase dans le comparateur 11.

Le multiplieur de fréquence 20 profite de tous les avantages du circuit verrouillé en phase 10 et de ceux d'un additionneur logique. On citera notamment la simplicité, la fiabilité et l'adaptation à une large bande de fréquences de fonctionnement. Par exemple, avec un signal d'entrée CL de période T variant entre 5 ns et 10 ns et avec un circuit à retard 13 de dix éléments de retard pouvant produire chacun un retard variant de 250 à 500 ps, il est possible d'obtenir à la sortie d'un multiplieur de fréquence conforme à l'invention une fréquence comprise dans une bande de 1 à 2GHz.

En plus des variantes de réalisation citées en référence au circuit verrouillé en phase 10 s'ajoutent toutes les variantes de réalisation bien connues de l'additionneur logique 16. Il est clair aussi que le facteur de multiplication dépend du nombre N d'éléments de retard dans le circuit à retard 13, du fonctionnement du circuit verrouillé en phase 10 et de la structure de l'additionneur logique 16. Par exemple, on pourrait supprimer les deux bascules 14′ et 15′ dans le comparateur de phase 11 et procéder à la comparaison de phase à chaque période T après deux passages dans les éléments 130-137. Si le signal d'entrée CL n'est pas carré, on pourrait par exemple disposer seize éléments de retard dans le circuit 10 de la figure 1, ou ajouter une interface entre le circuit 10 et l'additionneur logique 16 dans le multiplieur de fréquence 20.

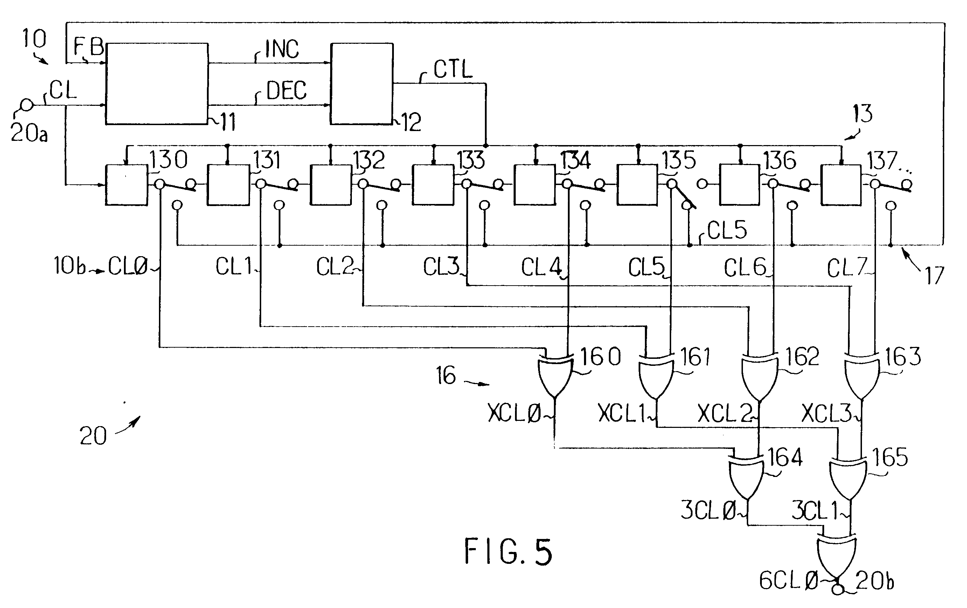

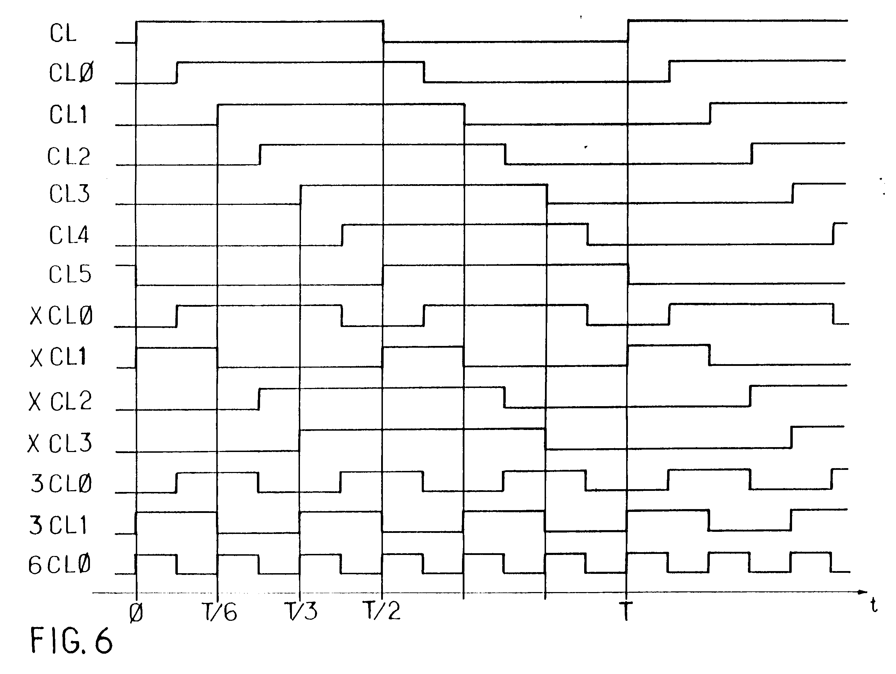

La figure 5 illustre schématiquement une variante de réalisation du multiplieur de fréquence 20. Tous les composants ont la même structure que celle décrite précédemment en référence à la figure 3. En d'autres termes, le ciruit verrouillé en phase 10 fournit à l'additionneur logique 16 tous les signaux de sortie des huit éléments de retard 130-137. La seule différence de la variante de réalisation avec celle représentée sur la figure 3 réside dans l'addition d'un dispositif de sélection tel qu'un multiplexeur 17 et dans l'adaptation au multiplexeur des liaisons entre les éléments de retard 130-137. Le multiplexeur 17 fournit le signal de contre-réaction FB à l'entrée de contre-réaction du comparateur de phase 11. Les entrées du multiplexeur 17 sont représentées schématiquement par des commutateurs reliant les éléments de retard entre eux et associés à la ligne fournissant le signal de contre-réaction FB. L'avantage du multiplexeur 17 est de faire varier le facteur de multiplication du multiplieur de fréquence 20. Dans l'exemple choisi et illustré dans les figures 5 et 6, le multiplexeur 17 maintient la liaison des six premiers éléments de retard 130-135 pour prélever le signal de contre-réaction FB à la sortie de l'élément 135 (FB = CL5). Les éléments de retard 136 et 137 sont écartés par le multiplexeur 17, mais leurs sorties respectives restent connectées à l'additionneur 16 et lui fournissent une valeur logique fixe prédéterminée. La figure 6 illustre les formes d'onde des signaux prélevés dans ces conditions du multiplieur de fréquence 20. Les signaux CL0-CL5 sont successivement retardés de la durée T/16 par rapport au signal d'entrée CL. Les portes 160-163 fournissent des signaux intermédiaires XCL0-XCL3 aux portes 164 et 165. Par rapport à la fréquence du signal d'entrée CL, celle des signaux de sortie 3CL0 et 3CL1 des portes 164 et 165 est triple, et celle du signal 6CL0 de la borne 20c est six fois plus grande. Bien sûr, l'homme du métier dispose d'autres variantes de réalisation d'un dispositif de sélection pour obtenir un facteur de multiplication désiré d'un multiplieur de fréquence conforme à l'invention.

## Revendications

1. Circuit verrouillé en phase (10) comprenant un comparateur de phase (11) recevant un signal d'entrée (CL) et un signal de contre-réaction (FB), caractérisé en ce que le signal de contre-réaction ainsi que les signaux de sortie sont produits par un circuit à retard de phase variable (13) du signal d'entrée, dont le retard est commandé par le signal de sortie du comparateur de phase.

2. Circuit selon la revendication 1, caractérisé en ce que le circuit à retard (13) se compose d'un nombre entier N d'éléments de retard (130-137) montés en série et produisant des retards respectifs égaux partageant l'intervalle de temps de deux fronts récurrents prédéterminés du signal d'entrée (CL).

3. Circuit selon la revendication 1 ou 2, caractérisé en ce que le circuit à retard (13) est commandé par le signal de sortie du comparateur de phase (11) par l'intermédiaire d'un dispositif de commande (12).

4. Circuit selon la revendication 3, caractérisé en ce que le dispositif de commande est un compteur-décompteur (12) et le signal de sortie du comparateur de phase (11) se compose d'un signal d'incrémentation (INC) et d'un signal de décrémentation (DEC) appliqués sur les bornes d'entrée respectives (12a, 12b) du compteur-décompteur.

5. Circuit selon l'une des revendications 2 à 4, caractérisé en ce que le comparateur de phase (11) inclut au moins une paire de bascules (14, 15) sensibles à l'un desdits fronts récurrents prédéterminés, dont les entrées de données reçoivent respectivement le signal d'entrée (CL) et le signal de contre-réaction (FB) et dont les entrées d'horloge reçoivent respectivement le signal de contre-réaction et le signal d'entrée.

6. Multiplieur de fréquence (20) mettant en oeuvre le circuit verrouillé en phase défini par l'une des revendications 1 à 5, comprenant un comparateur de phase (11) recevant un signal d'entrée (CL) et un signal de contre-réaction (FB), caractérisé en ce que le signal de contre-réaction est produit par un circuit à retard (13) produisant des retards successifs de phase du signal d'entrée commandés par le signal de sortie du comparateur de phase, et en ce que le signal de sortie du multiplieur est délivré par un additionneur logique (16) des signaux retardés.

7. Multiplieur selon la revendication 6, caractérisé en ce que l'additionneur logique (16) est un montage en arbre de portes OU Exclusif.

8. Multiplieur selon la revendication 6 ou 7, caractérisé en ce que le circuit à retard (13) se compose d'un nombre entier N d'éléments de retard (130-137) montés en série et produisant des retards respectifs égaux partageant l'intervalle de temps séparant deux fronts récurrents prédéterminés du signal d'entrée (CL), et le signal de contre-réaction (FB) est prélevé à la sortie du dernier élément de retard (137).

9. Multiplieur selon la revendication 6 ou 7, caractérisé en ce que le circuit à retard (13) se compose d'un nombre entier N d'éléments de retard (130-137) montés en série et en ce qu'un dispositif de sélection prélève le signal de contre-réaction (FB) de l'un des éléments de retard et déconnecte de celui-ci le ou les éléments de retard suivants.

10. Multiplieur selon l'une des revendications 6 à 9, caractérisé en ce que le circuit à retard (13) est commandé par le signal de sortie du comparateur de phase (11) par l'intermédiaire d'un dispositif de commande (12).

## Patentansprüche

1. Phasenregelschaltung (10) mit einem Phasenkomparator (11), der ein Eingangssignal (CL) und ein Gegenkopplungssignal (FB) empfängt, dadurch gekennzeichnet, daß das Gegenkopplungssignal sowie die Ausgangssignale von einer Verzögerungsschaltung (13) mit variabler Phasenverzögerung für das Eingangssignal erzeugt werden, deren Verzögerung durch das Ausgangssignal des Phasenkomparators gesteuert wird.

2. Schaltung nach Anspruch 1, dadurch gekennzeichnet, daß die Verzögerungsschaltung (13) aus einer ganzen Zahl N von in Reihe geschalteten Verzögerungselementen (130-137) zusammengesetzt ist, die jeweils gleiche Verzögerungen erzeugen, die sich das Zeitintervall von zwei vorbestimmten periodisch wiederkehrenden Flanken des Eingangssignals (CL) teilen.

3. Schaltung nach Anspruch 1 oder 2, dadurch gekennzeichnet, daß die Verzögerungsschaltung (13) durch das Ausgangssignal des Phasenkomparators (11) über eine Steuereinrichtung (12) gesteuert wird.

4. Schaltung nach Anspruch 3, dadurch gekennzeichnet, daß die Steuereinrichtung ein Aufwärts-/Abwärtszahler (12) ist und das Ausgangssignal des Phasenkomparators (11) aus einem Inkrementierungssignal (INC) und einem Dekrementierungssignal (DEC) zusammengesetzt ist, die an die Eingangsanschlüsse (12a bzw. 12b) des Aufwärts-/Abwärtszählers angelegt werden.

5. Schaltung nach einem der Ansprüche 2 bis 4, dadurch gekennzeichnet, daß der Phasenkomparator (11) wenigstens zwei Kippglieder (14, 15) umfaßt, die gegenüber einer der vorbestimmten periodisch wiederkehrenden Flanken empfindlich sind, deren Dateneingänge das Eingangssignal (CL) bzw. das Gegenkopplungssignal (FB) empfangen und deren Takteingänge das Gegenkopplungssignal bzw. das Eingangssignal empfangen.

6. Frequenzvervielfacher (20), der die durch einen der Ansprüche 1 bis 5 definierte Phasenregelschaltung verwendet und einen Phasenkomparator (11) aufweist, der ein Eingangssignal (CL) und ein Gegenkopplungssignal (FB) empfängt, dadurch gekennzeichnet, daß das Gegenkopplungssignal durch eine Verzögerungsschaltung (13) erzeugt wird, die aufeinanderfolgende Phasenverzögerungen des Eingangssignals erzeugt, die von dem Ausgangssignal des Phasenkomparators gesteuert werden, und daß das Ausgangssignal des Vervielfachers durch einen Logikaddierer (16) für die verzögerten Signale geliefert wird.

7. Vervielfacher nach Anspruch 6, dadurch gekennzeichnet, daß der Logikaddierer (16) eine baumförmige Schaltung von EXCLUSIV-ODER-Gliedern ist.

8. Vervielfacher nach Anspruch 6 oder 7, dadurch gekennzeichnet, daß die Verzögerungsschaltung (13) aus einer ganzen Zahl N von in Reihe geschalteten Verzögerungselementen (130-137) zusammengesetzt ist, die jeweils gleiche Verzögerungen erzeugen, die sich das Zeitintervall teilen, das zwei vorbestimmte periodisch wiederkehrende Flanken des Eingangssignals (CL) trennt, und das Gegenkopplungssingal (FB) am Ausgang des letzten Verzögerungselements (137) abgenommen wird.

9. Vervielfacher nach Anspruch 6 oder 7, dadurch gekennzeichnet, daß die Verzögerungsschaltung aus einer ganzen Zahl N von in Reihe geschalteten Verzögerungselementen (130-137) zusammengesetzt ist, und daß eine Auswahleinrichtung das Rückkopplungssignal (FB) eines der Verzögerungselemente abnimmt und das oder die folgenden Verzögerungselemente von diesem trennt.

10. Vervielfacher nach einem der Ansprüche 6 bis 9, dadurch gekennzeichnet, daß die Verzögerungsschaltung (13) durch das Ausgangssignal des Phasenkomparators über eine Steuereinrichtung (12) gesteuert wird.

## Claims

1. A phase-locked loop (10) comprising a phase comparator (11) receiving an input signal (CL) and a feedback signal (FB), characterised in that the feedback signal and the output signals are produced by a variable phase delay circuit (13) of the input signal, the delay of which is controlled by the output signal of the phase comparator.

2. A loop as claimed in Claim 1, characterised in that the delay circuit (13) consists of a whole number N of delay elements (130-137) connected in series, each introducing an equal delay dividing the time interval of two predetermined recurrent fronts of the input signal (CL).

3. A loop as claimed in Claim 1 or Claim 2, characterised in that the delay circuit (13) is controlled by the output signal of the phase comparator (11) via a control unit (12).

4. A loop as claimed in Claim 3, characterised in that the control unit is a reversible counter (12) and the output signal of the phase comparator (11) consists of an incrementation signal (INC) and a decrementation signal (DEC) which are applied to the respective input terminals (12a, 12b) of the reversible counter.

5. A loop as claimed in one of Claims 2 to 4, characterised in that the phase comparator (11) incorporates at least one pair of flip-flops (14,15) which are sensitive to one of said predetermined recurrent fronts, the data inputs of which receive the input signal (CL) and the feedback signal (FB) respectively and the clock inputs of which receive the feedback signal and the input signal respectively.

6. A frequency multiplier (20) using the phase-locked loop as defined by one of Claims 1 to 5, comprising a phase comparator (11) receiving an input signal (CL) and a feedback signal (FB), characterised in that the feedback signal is produced by a delay circuit (13) introducing successive phase delays of the input signal which are controlled by the output signal of the phase comparator, and in that the output signal of the multiplier is delivered by a logical adder (16) of the delayed signals.

7. A multiplier as claimed in Claim 6, characterised in that the logical adder (16) is a tree-structured exclusive-OR gate circuit.

8. A multiplier as claimed in Claim 6 or Claim 7, characterised in that the delay circuit (13) consists of a whole number N of delay elements (130-137) connected in series and each introducing an equal delay dividing the time interval separating two predetermined recurrent fronts of the input signal (CL), and in that the feedback signal (FB) is sampled at the output of the last delay element (137).

9. A multiplier as claimed in Claim 6 or Claim 7, characterised in that the delay circuit (13) consists of a whole number N of delay elements (130-137) connected in series, and in that a selection device samples the feedback signal (FB) of one of the delay elements and disconnects from the latter the following delay element or elements.

10. A multiplier as claimed in one of Claims 6 to 9, characterised in that the delay circuit (13) is controlled by the output signal of the phase comparator (11) via a control unit (12).
